# EUROPEAN PATENT APPLICATION

(11) **EP 4 822 371 A1**
(43) Date of publication of application: **14.10.2026**
(21) Application number: 25211663.7
(22) Date of filing: 28.10.2025
(51) Int. Cl.: G01R 31/392, B60L 3/00, B60L 58/16, G01R 31/396

(54) **BATTERY DIAGNOSIS APPARATUS AND METHOD FOR DETECTING MICRO INTERNAL SHORT CIRCUIT**

(30) Priority: 11.04.2025 KR 20250047380
(71) Applicant: Hyundai Motor Company, Seoul 06797 (KR); Kia Motors Corporation, Seoul 06797 (KR)
(72) Inventor: LEE, Junghyun, 18280 Hwaseong-si, Gyeonggi-do (KR)
(74) Representative: Viering, Jentschura & Partner mbB Patent- und Rechtsanwälte

(57) **Abstract**

The present disclosure relates to a battery diagnosis apparatus and a method for diagnosing a battery cell in which a micro internal short circuit has occurred during a cell balancing inactive period. A battery diagnosis apparatus according to one embodiment of the present disclosure may include a battery cell determination unit configured to determine, based on voltage variations of a plurality of battery cells, at least some of the plurality of battery cells as diagnostic reference cells for detecting a micro internal short circuit, and a battery cell diagnosis unit configured to diagnose a micro internal short circuit in each of the plurality of battery cells based on voltage variations of the diagnostic reference cells.

## Description

### CROSS-REFERENCE TO RELATED APPLICATION

This present application claims the benefit of priority to Korean Patent Application No. 10-2025-0047380, filed on April 11, 2025, in the Korean Intellectual Property Office, the entire disclosure of which is incorporated herein by reference.

### TECHNICL FIELD

The present disclosure relates to a battery diagnosis apparatus and a method for detecting a micro internal short circuit, and more particularly, to a battery diagnosis apparatus and a method for diagnosing a battery cell in which a micro internal short circuit has occurred during a cell balancing inactive period.

### BACKGROUND

The matters described in this Background section are only for enhancement of understanding of the background of the disclosure, and should not be taken as acknowledgment that they correspond to prior art already known to those skilled in the art.

A battery pack may include a plurality of battery cells connected in series and/or in parallel. A battery cell may include a positive electrode current collector, a negative electrode current collector, a separator, an active material, an electrolyte, and the like, and may perform repeated charging and discharging through electrochemical reactions among these components.

Battery cells are designed to have high density and high energy, and therefore, ensuring safety is critical since abnormal behavior may lead to hazardous situations. Abnormal behavior of battery cells may primarily manifest as voltage deviations between battery cells caused by their abnormal degradation. The voltage deviations between the battery cells may not only reduce battery capacity and lifespan but also accelerate cell degradation, creating a harmful operating environment. Therefore, a cell balancing function may be applied to ensure the stability of battery cells. The cell balancing function may monitor voltage deviations between battery cells and adjust the monitored voltage deviations among the battery cells.

However, when the ignition (IG) is switched to OFF state, a vehicle control unit (VCU), which is responsible for performing the cell balancing function, may also turn off, resulting in a cell balancing inactive period. During this period, the cell balancing function may not operate, and voltage deviations between battery cells may not be actively monitored.

### SUMMARY

The following summary presents a simplified summary of certain features. The summary is not an extensive overview and is not intended to identify key or critical elements.

The present disclosure is directed to providing a battery diagnosis apparatus and a method for diagnosing a battery cell in which a micro internal short circuit has occurred during a cell balancing inactive period.

In addition, the present disclosure is directed to providing a battery diagnosis apparatus and a method for detecting a micro internal short circuit, which may improve diagnostic sensitivity in diagnosing a micro internal short circuit in a battery cell.

The present disclosure is not limited to what has been described above, and other aspects not mentioned herein will be apparent from the following description to one of ordinary skill in the art to which the present disclosure pertains. Moreover, aspects of the present disclosure may be realized by the means and combinations thereof indicated in the claims.

According to the present disclosure, an apparatus of a vehicle may comprise a processor and a memory storing at least one instruction that, when executed by the processor, is configured to cause the apparatus to determine, based on voltage variations of a plurality of battery cells of the vehicle, at least one of the plurality of battery cells as at least one diagnostic reference cell for detecting formation of a micro internal short circuit in each of the plurality of battery cells, determine, based on voltage variations of the at least one diagnostic reference cell, whether a micro internal short circuit has formed in each of the plurality of battery cells, and output, based on a determination that the micro internal short circuit has formed, a signal indicating detection of formation of the micro internal short circuit.

The at least one instruction, when executed by the processor, may be configured to cause the apparatus to determine, as the at least one diagnostic reference cell, remaining battery cells other than an abnormal battery cell that has a greatest voltage variation among the plurality of battery cells.

The at least one instruction, when executed by the processor, may be configured to cause the apparatus to detect a micro internal short circuit in each of the plurality of battery cells based on a difference between a voltage variation of each of the plurality of battery cells and a median value of voltage variations of the at least one diagnostic reference cell.

The at least one instruction, when executed by the processor, may be configured to cause the apparatus to repeatedly detect, at least a target quantity of times, a battery cell among the plurality of battery cells as having a micro internal short circuit based on a difference exceeding a diagnostic threshold, wherein the difference is between the voltage variation of the battery cell and the median value of the voltage variations of the at least one diagnostic reference cell.

The at least one instruction, when executed by the processor, may be configured to cause the apparatus to determine a voltage variation for each battery cell among the plurality of battery cells as a difference between a first voltage of each battery cell and a second voltage of each battery cell, wherein the first voltage is an open circuit voltage measured in an ignition-off state of the vehicle, and wherein the second voltage is an open circuit voltage measured in an ignition-on state of the vehicle.

The at least one instruction, when executed by the processor, may be configured to cause the apparatus to store, as the first voltage, an open circuit voltage measured when a power of a vehicle control circuit of the vehicle is turned back on after the vehicle transitions into a turned-off state in response to the ignition-off state of the vehicle.

The at least one instruction, when executed by the processor, may be configured to cause the apparatus to initialize the first voltage and the second voltage based on a determination, in the ignition-on state, that the open circuit voltage stored as the first voltage is absent, and store, as the first voltage, an open circuit voltage measured in a next ignition-off state of the vehicle.

The at least one instruction, when executed by the processor, may be configured to cause the apparatus to store, as the second voltage, an open circuit voltage measured in the ignition-on state based on a state of charge of the plurality of battery cells being equal to or above a target level and a temperature of the plurality of battery cells being equal to or above a target temperature.

According to the present disclosure, a method performed by an apparatus of a vehicle may comprise determining, based on voltage variations of a plurality of battery cells of the vehicle, at least one of the plurality of battery cells as at least one diagnostic reference cell for detecting formation of a micro internal short circuit in each of the plurality of battery cells, determining, based on voltage variations of the at least one diagnostic reference cell, whether a micro internal short circuit has formed in each of the plurality of battery cells, and outputting, based on a determination that the micro internal short circuit has formed, a signal indicating detection of formation of the micro internal short circuit.

According to the present disclosure, a vehicle may comprise a battery pack that may comprise a plurality of battery cells, a sensor that may be configured to measure open circuit voltages of the plurality of battery cells, and a processor circuit that may be configured to store, as a first voltage, an open circuit voltage of each of the plurality of battery cells measured in an ignition-off state of the vehicle, store, as a second voltage, an open circuit voltage of each of the plurality of battery cells measured in an ignition-on state of the vehicle, determine a voltage variation of each of the plurality of battery cells based on a difference between the first voltage and the second voltage of the corresponding battery cell, identify at least one abnormal battery cell as a battery cell having a voltage variation greater than a threshold value, select, as diagnostic reference cells, remaining battery cells excluding the at least one abnormal battery cell, determine, for each of the plurality of battery cells, whether a micro internal short circuit has formed based on a comparison between the voltage variation of each of the plurality of battery cells and a median of the voltage variations of the diagnostic reference cells, and output an indicator associated with the micro internal short circuit.

The processor circuit may be configured to identify the at least one abnormal battery cell as a battery cell having a greatest voltage variation among the plurality of battery cells, wherein the greatest voltage variation exceeds the threshold value.

The processor circuit may be configured to determine that a micro internal short circuit has formed based on a difference between the voltage variation of one of the plurality of battery cells and the median exceeding a preset threshold voltage value.

The processor circuit may be configured to determine that a micro internal short circuit has formed based on detecting a difference exceeding a preset threshold voltage value for at least a preset quantity of times, and wherein the difference exceeding the preset threshold voltage value is between the voltage variation of one of the plurality of battery cells and the median.

The processor circuit may be configured to measure the second voltage under a predetermined operating condition, wherein the predetermined operating condition may comprise at least one of a state-of-charge condition of the battery pack or a temperature condition of the battery pack.

### BRIEF DESCRIPTION OF THE DRAWINGS

The foregoing and other aspects, features, and advantages, as well as the following detailed description of the embodiments, will be better understood when read in conjunction with the accompanying drawings. However, the present disclosure is not intended to be limited to the details shown in the drawings and various modifications and structural changes may be made therein without departing from the spirit of the present disclosure and within the scope and range of equivalents defined by the claims. Like reference numbers and designations in the various drawings indicate like elements.
FIG. 1 shows an example of a structure of a battery diagnosis environment.
FIG. 2 shows an example of a configuration of a battery diagnosis apparatus.
FIG. 3 shows an example of voltage variation values for a plurality of battery cells.
FIG. 4 shows an example of the distribution of voltage variations for a plurality of battery cells.
FIG. 5 shows an example of a median value of voltage variations for diagnostic reference cells.
FIG. 6 shows an example of a method for detecting a micro internal short circuit.
FIG. 7 shows an example computing system.

### DETAILED DESCRIPTION

Hereinafter, exemplary embodiments disclosed in the present document will be described in detail with reference to the accompanying drawings. Like reference numerals designate like elements, and redundant descriptions thereof will be omitted. Further, such as "module" and a "unit", suffixes for components used in the following description are given or mixed and used by considering easiness in preparing a specification and do not have a meaning or role distinguished from each other in themselves. In addition, in describing an embodiment disclosed in the present document, if it is determined that a detailed description of a related art incorporated herein unnecessarily obscure the gist of the embodiment, the detailed description thereof will be omitted. Furthermore, it should be understood that the appended drawings are intended only to help understand embodiments disclosed in the present document and do not limit the technical principles and scope of the present disclosure; rather, it should be understood that the appended drawings include all of the modifications, equivalents or substitutes described by the technical principles and belonging to the technical scope of the present disclosure.

Although the terms first, second, and the like, may be used herein to describe various elements, these elements should not be limited by these terms. These terms are generally only used to distinguish one element from another.

When an element or layer is referred to as being "on," "engaged to," "connected to," or "coupled to" another element or layer, it may be directly on, engaged, connected, or coupled to the other element or layer, or intervening elements or layers may be present. In contrast, when an element is referred to as being "directly on," "directly engaged to," "directly connected to," or "directly coupled to" another element or layer, there may be no intervening elements or layers present.

For purposes of this application and the claims, using the exemplary phrase "at least one of: A; B; or C" or "at least one of A, B, or C," the phrase means "at least one A, or at least one B, or at least one C, or any combination of at least one A, at least one B, and at least one C. Further, exemplary phrases, such as "A, B, and C", "A, B, or C", "at least one of A, B, and C", "at least one of A, B, or C", etc. as used herein may mean each listed item or all possible combinations of the listed items. For example, "at least one of A or B" may refer to (1) at least one A; (2) at least one B; or (3) at least one A and at least one B.

The term "module" or "unit" used in the specification means a software and/or hardware component, and the "module" or "unit" performs certain operations/functions/roles. However, the "module" or "unit" is not construed as being limited to software or hardware. The "module" or "unit" may be configured to be in an addressable storage medium or to execute one or more processors. Therefore, as an example, the "module" or "unit" may include at least one of components such as software components, object-oriented software components, class components, and task components, processes, functions, attributes, procedures, sub-routines, segments of program codes, drivers, firmware, micro-codes, circuits, data, databases, data structures, tables, arrays, or variables. Functions provided in the components, "modules", or "units" may be combined into a smaller number of components, "modules", or "units" or further divided into additional components, "modules", or "units".

In the present disclosure, the "module" or "unit" may be realized as a processor and a memory. The "processor" should be widely construed to include a general-purpose processor, a central processing unit (CPU), a microprocessor, a digital signal processor (DSP), a microcontroller, a state machine, or the like. In some environments, the "processor" may refer to an application-specific integrated circuit (ASIC), a programmable logic device (PLD), or a field-programmable gate array (FPGA), and the like. For example, the "processor" may refer to a combination of processing devices such as a combination of a DSP and a microprocessor, a combination of a plurality of microprocessors, a combination of one or more microprocessors combined with a DSP core, or any other such combination. Moreover, the "memory" should be widely construed to include any electronic component capable of storing electronic information. The "memory" may refer to various types of processor-readable medium such as a random access memory (RAM), a read only memory (ROM), a non-volatile random access memory (NVRAM), a programmable read only memory (PROM), an erasable programmable read only memory (EPROM), an electrically erasable programmable read only memory (EEPROM), a flash memory, a magnetic or optical data storage device, and registers. When the processor can read information from a memory and/or record the information in the memory, the memory may be in a state of electronic communication with a processor. Memory integrated into a processor is in a state of electronic communication with the processor.

The one or more features described herein may be provided as a computer program stored in a computer-readable recording medium in order to be executed on a computer. The medium may either continuously store a computer-executable program or temporarily store the program for execution or download. Furthermore, the medium may be a variety of recording or storage means in the form of a single hardware device or multiple combined hardware devices, and is not limited to media directly connected to some computer system but may also be distributed across a network. Examples of such media include magnetic media such as a hard disk, a floppy disk, or a magnetic tape, optical recording media such as a CD-ROM or a DVD, magneto-optical media such as a floptical disk, and a ROM, RAM, or flash memory, among others, configured to store program instructions. Additional examples of such media include media or storage media that are managed by an app store that distributes applications or by various other sites or servers that provide or distribute software.

In a hardware implementation, processing units used for performing the techniques may be implemented within one or more ASICs, DSPs, digital signal processing devices, programmable logic devices, field-programmable gate arrays, processors, controllers, microcontrollers, microprocessors, electronic devices, or computers or combinations thereof designed to perform the functions described in the present disclosure.

An automation level of an autonomous driving vehicle may be classified as follows, according to the American Society of Automotive Engineers (SAE). At autonomous driving level 0, the SAE classification standard may correspond to "no automation," in which an autonomous driving system is temporarily involved in emergency situations (e.g., automatic emergency braking) and/or provides warnings only (e.g., blind spot warning, lane departure warning, etc.), and a driver is expected to operate the vehicle. At autonomous driving level 1, the SAE classification standard may correspond to "driver assistance," in which the system performs some driving functions (e.g., steering, acceleration, brake, lane centering, adaptive cruise control, etc.) while the driver operates the vehicle in a normal operation section, and the driver is expected to determine an operation state and/or timing of the system, perform other driving functions, and cope with (e.g., resolve) emergency situations. At autonomous driving level 2, the SAE classification standard may correspond to "partial automation," in which the system performs steering, acceleration, and/or braking under the supervision of the driver, and the driver is expected to determine an operation state and/or timing of the system, perform other driving functions, and cope with (e.g., resolve) emergency situations. At autonomous driving level 3, the SAE classification standard may correspond to "conditional automation," in which the system drives the vehicle (e.g., performs driving functions such as steering, acceleration, and/or braking) under limited conditions but transfer driving control to the driver when the required conditions are not met, and the driver is expected to determine an operation state and/or timing of the system, and take over control in emergency situations but do not otherwise operate the vehicle (e.g., steer, accelerate, and/or brake). At autonomous driving level 4, the SAE classification standard may correspond to "high automation," in which the system performs all driving functions, and the driver is expected to take control of the vehicle only in emergency situations. At autonomous driving level 5, the SAE classification standard may correspond to "full automation," in which the system performs full driving functions without any aid from the driver including in emergency situations, and the driver is not expected to perform any driving functions other than determining the operating state of the system. Although the present disclosure may apply the SAE classification standard for autonomous driving classification, other classification methods and/or algorithms may be used in one or more configurations described herein.

One or more features associated with autonomous driving control may be activated based on configured autonomous driving control setting(s) (e.g., based on at least one of: an autonomous driving classification, a selection of an autonomous driving level for a vehicle, etc.). Based on one or more features (e.g., a feature of using diagnostic reference cells and median-based voltage variation to detect micro internal short circuits in battery cells) described herein, an operation of the vehicle may be controlled. The vehicle control may include various operational controls associated with the vehicle (e.g., autonomous driving control, sensor control, braking control, braking time control, acceleration control, acceleration change rate control, alarm timing control, forward collision warning time control, etc.). For example, when a micro internal short circuit is detected, the autonomous driving control may reduce the maximum driving level from full self-driving to highway-assist mode to ensure a safer operating margin. In another example, the braking control and acceleration control may be adjusted to limit high current draw from the compromised battery cells, thereby reducing stress on the battery pack. Additionally, when repeated micro internal short circuit detections occur, the system may trigger earlier forward collision warnings or shorten alarm timing thresholds to increase driver attentiveness and prepare for a possible handover of driving control.

One or more auxiliary devices (e.g., engine brake, exhaust brake, hydraulic retarder, electric retarder, regenerative brake, etc.) may also be controlled, for example, based on one or more features (e.g., a feature of using diagnostic reference cells and median-based voltage variation to detect micro internal short circuits in battery cells) described herein. For example, when a micro internal short circuit is detected, the regenerative braking system may be limited to reduce stress on the affected battery cells. In another example, auxiliary braking devices such as an exhaust brake or hydraulic retarder may be prioritized over regenerative braking to ensure vehicle deceleration without overloading the compromised battery. Additionally, when repeated micro internal short circuit detections occur, the control system may adjust the balance between mechanical braking and regenerative braking to maintain safety while minimizing further battery degradation.

One or more communication devices (e.g., a modem, a network adapter, a radio transceiver, an antenna, etc., that is capable of communicating via one or more wired or wireless communication protocols, such as Ethernet, Wi-Fi, near-field communication (NFC), Bluetooth, Long-Term Evolution (LTE), 5G New Radio (NR), vehicle-to-everything (V2X), etc.) may also be controlled, for example, based on one or more features (e.g., a feature of using diagnostic reference cells and median-based voltage variation to detect micro internal short circuits in battery cells) described herein. For example, when a micro internal short circuit is detected in one or more battery cells, the communication device may automatically transmit diagnostic alerts to a remote server or fleet management system. In another example, the vehicle may initiate a V2X message to nearby vehicles to signal potential reduced driving capability, thereby improving road safety. Additionally, when repeated micro internal short circuit detections occur, the communication devices may limit non-essential data transfers (e.g., infotainment streaming) and prioritize safety-critical communications (e.g., emergency calls, service scheduling, or remote battery health reporting).

Minimum risk maneuver (MRM) operation(s) may also be controlled, for example, based on one or more features (e.g., a feature of using diagnostic reference cells and median-based voltage variation to detect micro internal short circuits in battery cells) described herein. A minimal risk maneuvering operation (e.g., a minimal risk maneuver, a minimum risk maneuver) may be a maneuvering operation of a vehicle to minimize (e.g., reduce) a risk of collision with surrounding vehicles in order to reach a lowered (e.g., minimum) risk state. For example, when detection of a micro internal short circuit indicates that battery stability may be compromised, the MRM may be triggered to guide the vehicle to safely decelerate and stop at the shoulder of the road. In another example, if repeated micro internal short circuit detections occur during autonomous driving, the MRM may bias the vehicle to exit a highway at the nearest safe exit to avoid potential loss of propulsion in high-speed conditions. Additionally, when micro internal short circuit detection coincides with low state-of-charge conditions, the MRM may reroute the vehicle toward the closest charging or service station and bring the vehicle to a controlled stop there. A minimal risk maneuver may be an operation that may be activated during autonomous driving of the vehicle when a driver is unable to respond to a request to intervene. During the minimal risk maneuver, one or more processors of the vehicle may control a driving operation of the vehicle for a set period of time.

Biased driving operation(s) may also be controlled, for example, based on one or more features (e.g., a feature of using diagnostic reference cells and median-based voltage variation to detect micro internal short circuits in battery cells) described herein. A driving control apparatus may perform a biased driving control. To perform a biased driving, the driving control apparatus may control the vehicle to drive in a lane by maintaining a lateral distance between the position of the center of the vehicle and the center of the lane. For example, when the detection of a micro internal short circuit indicates that one or more battery cells may be unstable, the vehicle may be biased toward the outer edge of the lane to prepare for a controlled pull-over. In another example, if repeated micro internal short circuit detections suggest reduced battery reliability, the vehicle may be biased to maintain a greater lateral distance from adjacent vehicles, thereby providing a wider safety margin for emergency maneuvers. Additionally, when micro internal short circuit detection is combined with low state-of-charge conditions, the system may bias the vehicle toward an exit lane to enable an earlier safe stop or routing to a charging station. The driving control apparatus may identify or determine such a biased target lateral distance for biased driving control based on the diagnostic result to improve the vehicle's stability, safety, and/or performance under varying driving conditions.

One or more sensors (e.g., IMU sensors, camera, LIDAR, RADAR, blind spot monitoring sensor, line departure warning sensor, parking sensor, light sensor, rain sensor, traction control sensor, anti-lock braking system sensor, tire pressure monitoring sensor, seatbelt sensor, airbag sensor, fuel sensor, emission sensor, throttle position sensor, inverter, converter, motor controller, power distribution unit, high-voltage wiring and connectors, auxiliary power modules, charging interface, etc.) may also be controlled, for example, based on one or more features (e.g., a feature of using diagnostic reference cells and median-based voltage variation to detect micro internal short circuits in battery cells) described herein. An operation control for autonomous driving of the vehicle may include various driving control of the vehicle by the vehicle control device (e.g., acceleration, deceleration, steering control, gear shifting control, braking system control, traction control, stability control, cruise control, lane keeping assist control, collision avoidance system control, emergency brake assistance control, traffic sign recognition control, adaptive headlight control, etc.). For example, when a micro internal short circuit is detected based on diagnostic reference cells and median-based voltage variation, the system may reduce the power consumption of selected sensors (e.g., limiting LIDAR scanning frequency, switching RADAR into a low-power mode, or delaying activation of auxiliary sensors) to conserve energy and maintain safe driving control until the fault condition is addressed.

An autonomous driving level and/or autonomous driving activation/deactivation may also be controlled, for example, based on one or more features (e.g., a feature of using diagnostic reference cells and median-based voltage variation to detect micro internal short circuits in battery cells) described herein. A driving control apparatus may perform an autonomous driving level control (e.g., a change of an autonomous driving level, a change of a required user attentiveness, etc.) or cause deactivation of an autonomous driving operation. For example, by detecting that a micro internal short circuit has formed in one or more battery cells based on diagnostic reference cells and median-based voltage variation analysis, the system may change the autonomous driving level, increase a required user attentiveness level, or deactivate autonomous driving to ensure safety. By changing the required user attentiveness, the driver may be required to place his/her hands on the steering wheel more often (e.g., at least once in a threshold time period, such as five seconds, 30 seconds, 1 minute, etc.). By further adjusting the autonomous driving level, the system may limit certain autonomous driving functions (e.g., lane change, adaptive cruise, or highway assist) or deactivate video contents that may otherwise distract the driver on the display of the vehicle.

According to the present disclosure, a battery diagnosis apparatus and method are provided that enable detection of a micro internal short circuit in a battery cell during a cell balancing inactive period. When an ignition of a vehicle is turned off, a vehicle control unit that manages balancing between cells may also turn off, resulting in a period where voltage deviations among battery cells are not actively monitored. During this time, a micro internal short circuit may occur in a cell, leading to gradual self-discharge, accelerated degradation, and potential safety risks. To address this, the battery diagnosis apparatus may store and compare open circuit voltages of each cell measured in ignition-off and ignition-on states. By determining voltage variations between these states and identifying abnormal cells with the largest variations, the apparatus may use the remaining cells as diagnostic reference cells. Based on a comparison between the voltage variation of each cell and a representative value, such as a median variation of the reference cells, the apparatus may diagnose whether a micro internal short circuit has occurred. This approach may improve sensitivity and reliability of detection, thereby enhancing the stability and safety of battery operation even when the vehicle is not in use.

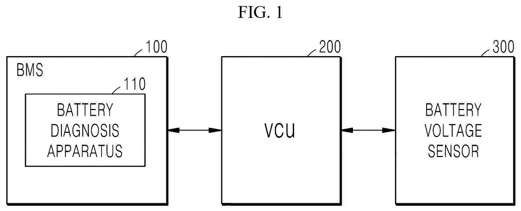

Hereinafter, a battery diagnosis apparatus and a method for detecting a micro internal short circuit according to embodiments of the present disclosure will be described in detail with reference to FIGS. 1 to 6.

Typically, abnormal behavior of battery cells may primarily manifest as voltage deviations between battery cells caused by abnormal degradation.

The voltage deviations between battery cells may not only reduce battery capacity and lifespan, but also accelerate the degradation of battery cells, thereby creating a harmful operating environment.

Therefore, a cell balancing function may be applied to ensure the stability of battery cells. The cell balancing function may monitor voltage deviations between battery cells and adjust the monitored voltage deviations among the battery cells.

However, when the ignition (IG) is switched to an off state, a vehicle control unit (VCU), which is responsible for performing the cell balancing function, may also turn off.

In such a situation, the off state of the VCU may lead to a cell balancing inactive period, during which the monitoring of voltage deviations between battery cells may be restricted.

In addition, during a vehicle inactivity period (e.g., long-term parking or when the vehicle is left unused) in which both the ignition and the VCU remain off, a cell balancing inactive period may also occur. In such a case, a micro internal short circuit may occur in a battery cell, resulting in self-discharge. This self-discharge may accelerate the degradation of the battery cell over time and threaten the stability of the battery cell. Therefore, a countermeasure may be required to address this issue.

One embodiment of the present disclosure may provide a method that enables diagnosis or determination of a micro internal short circuit in a battery cell even during a cell balancing inactive period caused by the off state of the VCU. Such a micro internal short circuit may occur, for example, due to lithium dendrite growth during fast charging at low temperature, separator shrinkage or cracking under high heat, metallic impurity particles such as copper or steel debris puncturing the separator, electrode misalignment or burrs abrading the separator under vibration, mechanical stress such as pouch swelling or external impact, or localized thermal hot spots near current collector tabs, etc.

FIG. 1 shows an example of a structure of a battery diagnosis environment according to one embodiment of the present disclosure.

Referring to FIG. 1, a battery diagnosis environment according to one embodiment of the present disclosure may include a battery management system (BMS) 100 that may communicate with a vehicle control unit (VCU) 200 and monitor voltage variations of a plurality of battery cells within a battery pack through the VCU 200 and a battery voltage sensor 300 (e.g., a voltage sensing integrated circuit, a current sensor, or a temperature-compensated measurement sensor, etc.).

The BMS 100 may include a battery diagnosis apparatus 110. The battery diagnosis apparatus 110 may be configured to diagnose a micro internal short circuit in each of a plurality of battery cells based on voltage variations of the plurality of battery cells monitored, during a cell balancing inactive period caused by the off state of the VCU (e.g., when the vehicle is parked, during long-term storage, or when auxiliary loads are disconnected, etc.).

The voltage variation of a battery cell may include a difference between a voltage of the battery cell measured in an ignition-off (IG off) state and a voltage of the battery cell measured in an ignition-on (IG on) state (e.g., when the key is turned off versus when the key is turned on, when the vehicle enters sleep mode versus wake-up mode, or when electronic control units switch states, etc.).

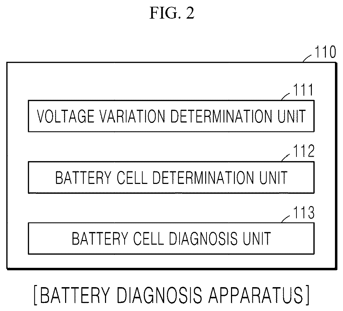

The following describes a battery diagnosis apparatus according to one embodiment of the present disclosure with reference to FIGS. 2 to 5.

FIG. 2 shows an example of a configuration of a battery diagnosis apparatus 110 according to one embodiment of the present disclosure.

Referring to FIG. 2, a battery diagnosis apparatus 110 according to one embodiment of the present disclosure may include a memory having instructions stored thereon and a processor configured to execute the instructions stored in the memory (e.g., flash memory, dynamic RAM, or solid-state storage devices, etc.).

The processor according to one embodiment of the present disclosure may include a functional configuration including a voltage variation determination unit 111, a battery cell determination unit 112, and a battery cell diagnosis unit 113, according to functionalities implemented by executing the instructions (e.g., software modules, firmware routines, or embedded control logic, etc.).

The battery diagnosis apparatus 110 according to one embodiment of the present disclosure may be configured to diagnose a micro internal short circuit in a battery cell, during a cell balancing inactive period, through functional units implemented by the processor as described above. The following provides a more detailed explanation of each functional unit that enables the diagnosis of a micro internal short circuit in the battery cell (e.g., voltage detection logic, abnormal cell identification, or statistical threshold comparison, etc.).

The voltage variation determination unit 111 may store, as a first voltage, an open circuit voltage (OCV) measured in an ignition-off (IG off) state for each of the plurality of battery cells (e.g., lithium-ion cells, nickel-metal hydride cells, or solid-state cells, etc.).

For example, the voltage variation determination unit 111 may be configured to store, as the first voltage, an open circuit voltage (OCV) measured when the vehicle control unit (VCU) first wakes up after transitioning to an off state in response to ignition-off (IG off) (e.g., a scheduled wake-up by a real-time clock, a remote signal wake-up, or an auxiliary power cycle, etc.).

The point in time when the vehicle control unit (VCU) first wakes up after transitioning to the off state corresponds to a moment when battery polarization is minimized, and an open circuit voltage (OCV) is measured at this time to determine the battery's final charging voltage (V_finish). This helps prevent misdiagnosis in the micro internal short circuit detection logic due to voltage differences caused by the battery polarization (e.g., voltage relaxation after load removal, stabilization of electrode potential, or diffusion-induced changes, etc.).

The voltage variation determination unit 111 may be configured to check whether the first voltage stored in a previous ignition-off (IG off) state exists when the ignition is switched to the on (IG on) state (e.g., key insertion, push-button start, or remote start command, etc.).

When the first voltage stored in the previous ignition-off (IG off) state does not exist, the voltage variation determination unit 111 may be configured to initialize the first voltage (Ig off_ocv) and the second voltage (Ig on _ocv), and store, as the first voltage, an OCV measured in a next ignition-off (IG off) state (e.g., after the next parking event, after a scheduled shutdown, or after a reset cycle, etc.).

The voltage variation determination unit 111 may be configured to store, as a second voltage, an open circuit voltage (OCV) measured in an ignition-on (IG on) state for each of the plurality of battery cells (e.g., after system boot-up, when auxiliary loads are reconnected, or when charging starts, etc.).

The voltage variation determination unit 111 may be configured to first determine whether a predetermined operating condition is satisfied, and if the condition is satisfied, store, as a second voltage, an open circuit voltage (OCV) measured in an ignition-on (IG on) state (e.g., when temperature sensors indicate normal ranges, when state of charge is stable, or when calibration intervals are met, etc.).

Here, the operating condition is intended to prevent misdiagnosis due to severe voltage deviations between battery cells under low state of charge (SOC) and low temperature conditions, and may be defined using a target SOC level (e.g., 20%) and a target temperature (e.g., 0°C) (e.g., SOC above 30% in some designs, temperature above 5°C, or adjusted thresholds for cold-weather vehicles, etc.).

The voltage variation determination unit 111 may be configured to store, as the second voltage, an open circuit voltage (OCV) measured under the predetermined operating condition, wherein the operating condition includes that, in the ignition-on (IG on) state, the state of charge (SOC) is at or above a target level (e.g., 20%) and the temperature is at or above a target temperature (e.g., 0°C) (e.g., SOC ≥ 40% in hybrid vehicles, temperature ≥ 10°C in summer operation, or manufacturer-defined thresholds, etc.).

The voltage variation determination unit 111 may be configured to determine the voltage variation for each battery cell among the plurality of battery cells based on a difference between the first voltage of each battery cell measured in an ignition-off (IG off) state and the second voltage of each battery cell measured in an ignition-on (IG on) state (e.g., ΔV of 0.01 V, ΔV of 0.1 V, or ΔV exceeding a preset limit, etc.).

The battery cell determination unit 112 may be configured to determine at least some of the plurality of battery cells as diagnostic reference cells for detecting a micro internal short circuit, based on voltage variations determined for each of the plurality of battery cells (e.g., selecting median cells, excluding outlier cells, or applying statistical filtering, etc.).

For example, the battery cell determination unit 112 may be configured to determine, as an abnormal battery cell, a specific battery cell having the greatest voltage variation (voltage drop) among the plurality of battery cells and to determine the remaining battery cells, excluding the abnormal battery cell, as diagnostic reference cells for detecting a micro internal short circuit (e.g., cells with voltage drop >0.2 V, cells showing repeated imbalance, or cells exceeding aging limits, etc.).

In one embodiment of the present disclosure, diagnostic reference cells are determined among the plurality of battery cells, so that a micro internal short circuit in each of the plurality of battery cells may be diagnosed based on the voltage variations of the diagnostic reference cells, excluding the abnormal battery cell. This is intended to improve diagnostic sensitivity compared to a case in which the voltage variation of the abnormal battery cell is also included (e.g., when only average values are used, when faulty cells distort results, or when a single weak cell masks true behavior of healthy cells, etc.).

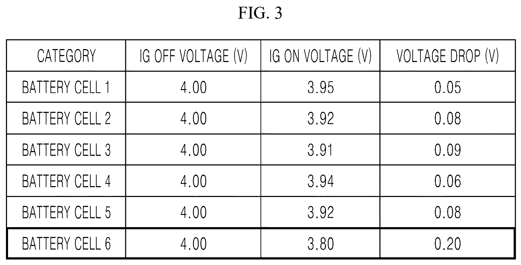

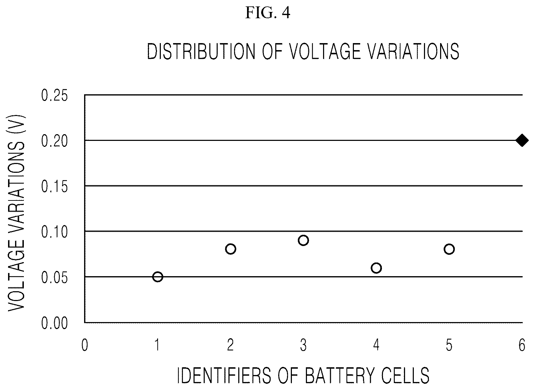

In this regard, FIG. 3 shows an example of voltage variation values for a plurality of battery cells according to one embodiment of the present disclosure. FIG. 4 shows an example of the distribution of voltage variations for a plurality of battery cells according to one embodiment of the present disclosure.

Referring to FIGS. 3 and 4, it may be seen that, among battery cells 1 to 6, battery cell 6 has the greatest voltage variation (0.2 V). In such a situation, battery cell 6, which has the greatest voltage variation, may be determined as an abnormal battery cell, and the remaining battery cells 1 to 5 may be determined as diagnostic reference cells for detecting a micro internal short circuit (e.g., imbalance caused by aging, local defects, or repeated deep discharges, etc.).

In one embodiment of the present disclosure, a method of determining, as an abnormal battery cell, a particular battery cell having the greatest voltage variation among the plurality of battery cells has been described. However, embodiments of the present disclosure are not limited thereto. According to another embodiment, one or more battery cells may also be determined as abnormal battery cells when the voltage variation of an individual battery cell exceeds a predetermined threshold, or when a difference between the voltage variation of a battery cell and those of other battery cells exceeds the threshold (e.g., more than 50 mV deviation, a percentage deviation of 10% or more, or repeated threshold violations across cycles, etc.).

The battery cell diagnosis unit 113 may be configured to diagnose a micro internal short circuit in each of the plurality of battery cells based on voltage variations of the diagnostic reference cells, after the diagnostic reference cells have been determined (e.g., reference cells chosen by median filtering, statistical clustering, or ranking methods, etc.).

The battery cell diagnosis unit 113 may be configured to determine a median value of the voltage variations of the diagnostic reference cells and determine, for each battery cell, a difference between a voltage variation of each battery cell and the median value of the voltage variations of the diagnostic reference cells (e.g., difference of 0.01 V, 0.05 V, or 0.1 V, etc.).

In one embodiment of the present disclosure, a method of diagnosing a micro internal short circuit in each of a plurality of battery cells is described based on a median value of voltage variations of the diagnostic reference cells. However, embodiments of the present disclosure are not limited thereto. According to another embodiment, a method of diagnosing a micro internal short circuit in each of a plurality of battery cells may use, as a reference, an average value of the voltage variations of the diagnostic reference cells (e.g., simple average, weighted average, or moving average over recent cycles, etc.).

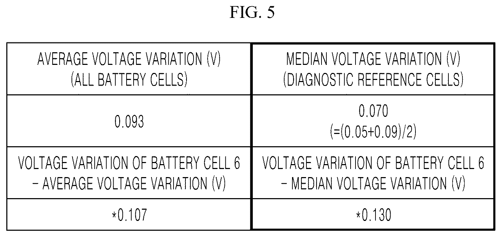

FIG. 5 shows an example of a median value of voltage variations for diagnostic reference cells according to one embodiment of the present disclosure.

FIG. 5 is a result based on the voltage variations of each battery cell shown in FIGS. 3 and 4.

Referring to FIG. 5, a difference may be observed between the average voltage variation (0.093 V) of all battery cells and the median voltage variation (0.070 V) of the diagnostic reference cells excluding an abnormal battery cell that has the greatest voltage variation (e.g., exclusion of cell 6 in the illustrated case, exclusion of cells repeatedly exceeding a deviation margin, or exclusion of outliers in different driving cycles, etc.).

The difference between the voltage variation (0.2V) of abnormal battery cell 6 and the average voltage variation (0.093V) of all battery cells is 0.107V. Similarly, the difference between the voltage variation (0.2V) of battery cell 6 and the median voltage variation (0.070V) of the diagnostic reference cells is 0.130V. Since a greater difference in voltage variation may enhance the sensitivity of diagnosing a micro internal short circuit, using the median value of the voltage variations of the diagnostic reference cells may result in improved diagnostic sensitivity (e.g., enabling earlier fault detection, distinguishing true short-circuit behavior from noise, or reducing false positives caused by temperature drift or sensor errors, etc.). Accordingly, when the diagnostic threshold is, for example, 120 mV or higher, a micro internal short circuit in each of a plurality of battery cells may be diagnosed based on the median value of the voltage variations of the diagnostic reference cells, thereby improving diagnostic sensitivity (e.g., enabling early detection of leakage pathways, improving accuracy under fluctuating loads, or reducing false positives under low SOC conditions, etc.).

The battery cell diagnosis unit 113 may be configured to determine, for each of the plurality of battery cells, a difference between the voltage variation of each battery cell and the median value of the voltage variations of the diagnostic reference cells, and to diagnose a micro internal short circuit in each battery cell based on a comparison between the determined difference and a diagnostic threshold (e.g., 3 mV) (e.g., 3 mV, 5 mV, or a dynamically adjusted threshold depending on temperature, etc.).

For example, the battery cell diagnosis unit 113 may be configured to diagnose a battery cell as having a micro internal short circuit based on a difference between the voltage variation of the battery cell and the median value of the voltage variations of the diagnostic reference cells exceeding a diagnostic threshold (e.g., 3 mV), and on repeated detection, at least a target number of times (e.g., three times), of the difference exceeding the diagnostic threshold (e.g., consecutive detections across three ignition cycles, repeated daily checks, or multiple detections in both charging and discharging modes, etc.).

To this end, the battery cell diagnosis unit 110 may be configured to, whenever the ignition is switched from the off state to the on state, detect battery cells having differences between their voltage variation and the median value of the voltage variations of the diagnostic reference cells that exceed a diagnostic threshold (e.g., 3 mV), and to accumulate and store the identifiers of the detected battery cells (e.g., storing cell IDs, logging timestamps, or updating fault history records, etc.).

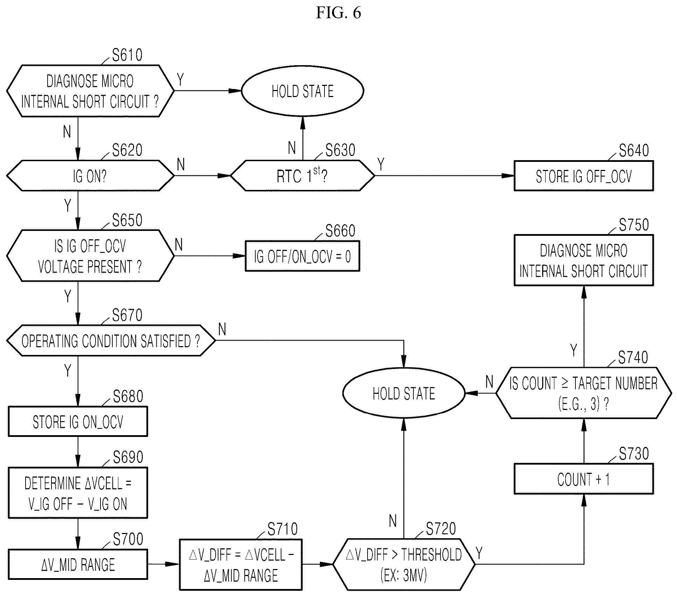

Hereinafter, a method for detecting a micro internal short circuit according to one embodiment of the present disclosure will be described with reference to FIG. 6. The method may be performed by the battery diagnosis apparatus 110 described above with reference to FIG. 2.

FIG. 6 shows an example of a method for detecting a micro internal short circuit according to one embodiment of the present disclosure.

In steps S610 to S640, the battery diagnosis apparatus 110 may be configured to store, as a first voltage (Ig off_ocv), an open circuit voltage (OCV) measured in an ignition-off (IG off) state for each of a plurality of battery cells (e.g., lithium-ion, nickel-metal hydride, or solid-state battery cells, etc.).

For example, after the ignition is switched to off state (IG off), the battery diagnosis apparatus 110 may be configured to store, as the first voltage (IG off_ocv), the open circuit voltage (OCV) measured for each battery cell when the vehicle control unit (VCU) first wakes up (RTC 1st, Real Time Clock 1st) after being switched to the off state (e.g., vehicle power first turns back on based on periodic wake-up, remote wake-up, or auxiliary power reactivation, etc.).

The point in time when the vehicle control unit (VCU) first wakes up (RTC 1^{st}) after transitioning to the off state corresponds to a moment when battery polarization is minimized, and an open circuit voltage (OCV) is measured at this time to determine the battery's final charging voltage (V_finish). This helps prevent misdiagnosis in the micro internal short circuit detection logic due to voltage differences caused by battery polarization (e.g., relaxation effects, temperature gradients, or sensor drift, etc.).

When the ignition is switched to on state (IG on), in S650, the battery diagnosis apparatus 110 may be configured to determine whether the first voltage (IG off_ocv) stored during the previous ignition-off (IG off) state exists (e.g., previously stored during a prior parking event, charging stop, or system reset, etc.).

When the first voltage (IG off_ocv) stored during the previous ignition-off (IG off) state does not exist, in S660, the battery diagnosis apparatus 110 may be configured to initialize the first voltage (IG off_ocv) and a second voltage (IG on _ocv), and to store, as the first voltage (IG off_ocv), an open circuit voltage (OCV) measured during a next ignition-off state (e.g., after the next shutdown cycle, after a maintenance mode, or after a deep-sleep state, etc.).

In S670 and S680, the battery diagnosis apparatus 110 may be configured to store, as the second voltage (IG on_ocv), an open circuit voltage (OCV) measured in the ignition-on (IG on) state for each of the plurality of battery cells (e.g., during startup, during charging initiation, or during accessory power activation, etc.).

The battery diagnosis apparatus 110 may be configured to first determine whether a predetermined operating condition is satisfied, and if the condition is satisfied, store, as the second voltage (IG on_ocv), an open circuit voltage (OCV) measured in the ignition-on (IG on) state (e.g., SOC within safe range, temperature above a minimum threshold, or stable current load, etc.).

Here, the operating condition is intended to prevent misdiagnosis due to severe voltage deviations between battery cells under low state of charge (SOC) and low temperature conditions, and may be defined using a target SOC level (e.g., 20%) and a target temperature (e.g., 0°C) (e.g., SOC ≥ 30%, temperature ≥ 5°C, or manufacturer-defined thresholds, etc.).

The voltage variation determination unit 111 may be configured to store, as the second voltage (IG on_ocv), an open circuit voltage (OCV) measured under the predetermined operating condition, wherein the operating condition includes that, in the ignition-on (IG on) state, the state of charge (SOC) is at or above a target level (e.g., 20%) and the temperature is at or above a target temperature (e.g., 0°C) (e.g., SOC ≥ 40% for hybrid vehicles, temperature ≥ 10°C in warm climates, etc.).

In S690, for each of the plurality of battery cells, the battery diagnosis apparatus 110 may be configured to determine voltage variations (ΔVcell) for each battery cell as differences between a first voltage (IG off_ocv) of each battery cell measured in the ignition-off state and a second voltage of each battery cell measured in the ignition-on state (e.g., ΔV of 0.01 V, 0.05 V, or more than 0.1 V, etc.).

When the voltage variations (ΔVcell) are determined for each battery cell, the battery diagnosis apparatus 110 may be configured to determine at least some of the plurality of battery cells as diagnostic reference cells for detecting a micro internal short circuit, based on the voltage variations (ΔVcell) (e.g., selecting median values, excluding outliers, or applying ranking logic, etc.).

For example, the battery diagnosis apparatus 110 may be configured to determine, as an abnormal battery cell, a specific battery cell having the greatest voltage variation (voltage drop) among the plurality of battery cells and to determine the remaining battery cells, excluding the abnormal battery cell, as diagnostic reference cells for detecting a micro internal short circuit (e.g., abnormal cell dropping by 0.2 V, while reference cells remain stable within ±0.05 V, etc.).

In one embodiment of the present disclosure, diagnostic reference cells are determined among a plurality of battery cells, so that a micro internal short circuit in each of the plurality of battery cells may be diagnosed based on the voltage variations of the diagnostic reference cells, excluding the abnormal battery cell. This is intended to improve diagnostic sensitivity compared to a case in which the voltage variation of the abnormal battery cell is also included (e.g., reducing error from faulty cells, improving accuracy under load changes, or avoiding skew from single outliers, etc.).

Meanwhile, in one embodiment of the present disclosure, a method of determining, as an abnormal battery cell, a specific battery cell having the greatest voltage variation among the plurality of battery cells has been described. However, the embodiments of the present disclosure are not limited thereto. According to another embodiment, one or more battery cells may also be determined as abnormal battery cells when the voltage variation of an individual battery cell exceeds a predetermined threshold, or when the difference between the voltage variation of a battery cell and those of other battery cells exceeds the threshold (e.g., deviations greater than 50 mV, repeated faults across cycles, or cells outside statistical tolerance bands, etc.).

When the diagnostic reference cells are determined from the plurality of battery cells, the battery diagnosis apparatus 110 may be configured to diagnose a micro internal short circuit in each of the plurality of battery cells based on the voltage variations (ΔVcell) of the diagnostic reference cells (e.g., comparing against median reference, weighted average, or adaptive thresholds, etc.).

In S700 and S710, the battery diagnosis apparatus 110 may be configured to determine a median value (ΔV_mid range) of the voltage variations (ΔVcell) of the diagnostic reference cells, and determine a difference (V_diff) between the voltage variation (ΔVcell) of each of the plurality of battery cells and the median value (ΔV_mid range) of the voltage variations of the diagnostic reference cells (e.g., 0.02 V, 0.05 V, or larger deviations, etc.).

In one embodiment of the present disclosure, the method for diagnosing a micro internal short circuit in each of the plurality of battery cells is described based on the median value (ΔV_mid range) of voltage variations of the diagnostic reference cells. However, embodiments of the present disclosure are not limited thereto. According to another embodiment, a method for diagnosing a micro internal short circuit in each of a plurality of battery cells may use, as a reference, an average value of the voltage variations of the diagnostic reference cells (e.g., mean value, trimmed mean, or weighted average adjusted by temperature, etc.).

When the differences (V_diff) are determined, in S720 to S750, the battery diagnosis apparatus 110 may be configured to compare the determined differences (V_diff) with a diagnostic threshold (e.g., 3 mV) and diagnose a micro internal short circuit in each of a plurality of battery cells based on the comparison result (e.g., exceeding 3 mV, 5 mV, or dynamic thresholds adjusted by SOC or temperature, etc.).

For example, the battery diagnosis apparatus 110 may be configured to diagnose a battery cell as having a micro internal short circuit based on the difference (V_diff) between the voltage variation (ΔVcell) of the battery cell and the median value (ΔV_mid range) of the voltage variations of the diagnostic reference cells exceeding a diagnostic threshold (e.g., 3 mV), and on repeated detection, at least a target number of times (e.g., three times), of the difference exceeding the diagnostic threshold (e.g., across three ignition cycles, during multiple charging events, or over multiple discharging cycles, etc.).

To this end, the battery diagnosis apparatus 110 may be configured to, whenever the ignition is switched from the off state (IG off) to the on state (IG on), detect battery cells having a difference (V_diff) between their voltage variation (ΔVcell) and the median value (ΔV_mid range) of the voltage variations of the diagnostic reference cells that exceeds a diagnostic threshold (e.g., 3 mV), and to accumulate and store the identifiers of the detected battery cells (e.g., by recording cell IDs, logging time stamps, or updating a fault history memory, etc.).

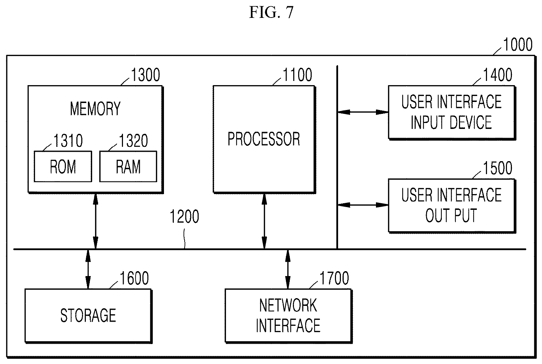

FIG. 7 shows an example computing system (e.g., a computing device of a vehicle or any other apparatus). One or more controllers, processors, etc. described herein, such as one or more components of the battery management system (BMS) 100 , one or more components of the vehicle control unit (VCU) 200, or any other components and devices disclosed herein, may be implemented by or in the computing system as shown in FIG. 7.

A computing system 1000 may include at least one processor 1100, memory 1300, a user interface input device 1400, a user interface output device 1500, a storage 1600, and a network interface 1700, which are connected with each other via a bus 1200.

The processor 1100 may be a central processing unit (CPU) or a semiconductor device that processes instructions stored in the memory 1300 and/or the storage 1600. Each of the memory 1300 and the storage 1600 may include various types of volatile or nonvolatile storage media. For example, the memory 1300 may include a read-only memory (ROM) and a random-access memory (RAM).

Communication interface(s) (also referred to as communication device(s), communicator(s), communication module(s), communication unit(s), etc.), such as the network interface 1700, may allow software and/or data to be transferred between a device and one or more external devices, and/or between one or more components of a device. Communication interface(s) may include a receiver, a transmitter, a transceiver, a modem, a network interface and/or adapter (such as an Ethernet adapter), a radio transceiver, an antenna, a communication port, a Personal Computer Memory Card International Association (PCMCIA) slot and card, or the like. Software and data transferred via communication interface(s) may be in the form of signals, which may be electronic, electromagnetic, optical, infrared, or other signals capable of being received by communication interface(s). These signals may be provided to communication interface(s) via a communication path of a device, which may be implemented using, for example, wire or cable, fiber optics, a cellular link, a radio frequency (RF) link and/or other communications channels. Communication interface(s) may communicate using one or more communication protocols, such as Ethernet, Wi-Fi, near-field communication (NFC), Infrared Data Association (IrDA), Bluetooth, Bluetooth low energy (BLE), Zigbee, Long-Term Evolution (LTE), 5G New Radio (NR), vehicle-to-everything (V2X), a controller area network (CAN), or a local interconnect network (LIN), etc.

Accordingly, the operations of the method or algorithm described in connection with example embodiment(s) disclosed in the specification may be directly implemented with a hardware module, a software module, or a combination of the hardware module and the software module, which is executed by the processor 1100. The software module may reside on a storage medium (e.g., the memory 1300 and/or the storage 1600) such as RAM, a flash memory, ROM, an erasable and programmable ROM (EPROM), an electrically EPROM (EEPROM), a register, a hard disk drive, a removable disc, or a compact disc-ROM (CD-ROM).

The storage medium may be coupled to the processor 1100. The processor 1100 may read out information from the storage medium and may write information in the storage medium. Alternatively, the storage medium may be integrated with the processor 1100. The processor and storage medium may be implemented with an application specific integrated circuit (ASIC). The ASIC may be provided in a user terminal. Alternatively, the processor and storage medium may be implemented with separate components in the user terminal.

An aspect of the present disclosure may provide a battery diagnosis apparatus including a battery cell determination unit configured to determine, based on voltage variations of a plurality of battery cells, at least some of the plurality of battery cells as diagnostic reference cells for detecting a micro internal short circuit, and a battery cell diagnosis unit configured to diagnose a micro internal short circuit in each of the plurality of battery cells based on voltage variations of the diagnostic reference cells.

The battery cell determination unit may be configured to determine, as the diagnostic reference cells, remaining battery cells other than an abnormal battery cell that has the greatest voltage variation among the plurality of battery cells.

The battery cell diagnosis unit may be configured to diagnose a micro internal short circuit in each of the plurality of battery cells based on a difference between a voltage variation of each of the plurality of battery cells and a median value of voltage variations of the diagnostic reference cells.

The battery cell diagnosis unit may be configured to diagnose a battery cell among the plurality of battery cells as having a micro internal short circuit, based on a difference between the voltage variation of the battery cell and the median value of the voltage variations of the diagnostic reference cells exceeding a diagnostic threshold, and on repeated detection, at least a target number of times, of the difference exceeding the diagnostic threshold.

The battery diagnosis apparatus may further include a voltage variation determination unit configured to determine a voltage variation for each battery cell as a difference between a first voltage of each battery cell, which is an open circuit voltage (OCV) measured in an ignition-off (IG off) state, and a second voltage of each battery cell, which is an open circuit voltage (OCV) measured in an ignition-on (IG on) state.

Another aspect of the present disclosure may provide a battery diagnosis apparatus including a memory having instructions stored thereon, and a processor configured to, by executing the instructions, determine, based on voltage variations of a plurality of battery cells, at least some of the plurality of battery cells as diagnostic reference cells for detecting a micro internal short circuit, and diagnose a micro internal short circuit in each of the plurality of battery cells based on voltage variations of the diagnostic reference cells.

Still another aspect of the present disclosure may provide a method for detecting a micro internal short circuit performed by a battery diagnosis apparatus, the method including determining, based on voltage variations of a plurality of battery cells, at least some of the plurality of battery cells as diagnostic reference cells for detecting a micro internal short circuit, and diagnosing a micro internal short circuit in each of the plurality of battery cells based on voltage variations of the diagnostic reference cells.

The determining at least some of the plurality of battery cells as diagnostic reference cells for detecting a micro internal short circuit may include determining, as the diagnostic reference cells, remaining battery cells other than an abnormal battery cell that has the greatest voltage variation among the plurality of battery cells.

The diagnosing a micro internal short circuit in each of the plurality of battery cells may include diagnosing a micro internal short circuit in each of the plurality of battery cells based on a difference between a voltage variation of each of the plurality of battery cells and a median value of voltage variations of the diagnostic reference cells.

The diagnosing a micro internal short circuit in each of the plurality of battery cells may include diagnosing a battery cell among the plurality of battery cells as having a micro internal short circuit, based on a difference between the voltage variation of the battery cell and the median value of the voltage variations of the diagnostic reference cells exceeding a diagnostic threshold, and on repeated detection, at least a target number of times, of the difference exceeding the diagnostic threshold.

The method for detecting a micro internal short circuit may further include determining a voltage variation for each battery cell as a difference between a first voltage of each battery cell, which is an open circuit voltage (OCV) measured in an ignition-off (IG off) state, and a second voltage of each battery cell, which is an OCV measured in an ignition-on (IG on) state.

According to embodiments of the present disclosure, a micro internal short circuit in each of a plurality of battery cells may be diagnosed by comparing a voltage variation of each of the plurality of battery cells with a reference value based on voltage variations of the plurality of battery cells. This may allow for diagnosing a micro internal short circuit in each of the plurality of battery cells, during a cell balancing inactive period.

In addition, according to embodiments of the present disclosure, in the process of diagnosing a micro internal short circuit in each of a plurality of battery cells, a battery cell having the largest voltage variation among the plurality of battery cells may be determined as an abnormal cell. The abnormal cell may be excluded from the diagnostic reference cells for detecting a micro internal short circuit, thereby improving diagnostic sensitivity.

As used in the present disclosure (especially in the appended claims), the terms "a/an" and "the" include both singular and plural references, unless the context clearly indicates otherwise. Also, it should be understood that any numerical range recited in the present disclosure is intended to include all sub-ranges subsumed therein (unless expressly indicated otherwise) and accordingly, the disclosed numerical ranges include every individual value between the minimum and maximum values of the numerical ranges.

The steps constituting the method according to the present disclosure may be performed in an appropriate order unless a specific order is described or otherwise specified. That is, the present disclosure is not necessarily limited to the order in which the steps are recited. All examples described in the present disclosure or the terms indicative thereof ("for example", "such as") are merely intended to describe the present disclosure in greater detail. Therefore, it should be understood that the scope of the present disclosure is not limited to the example embodiments described above or by the use of such terms unless limited by the appended claims. Also, it should be apparent to those skilled in the art that various modifications, combinations, and alterations may be made depending on design conditions and factors within the scope of the appended claims or equivalents thereof.

The present disclosure is thus not limited to the example embodiments described above, and rather intended to include the following appended claims, and all modifications, equivalents, and alternatives falling within the spirit and scope of the following claims.

## Claims

1. An apparatus of a vehicle, the apparatus comprising:
a processor; and
a memory storing at least one instruction that, when executed by the processor, is configured to cause the apparatus to:
determine, based on voltage variations of a plurality of battery cells of the vehicle, at least one of the plurality of battery cells as at least one diagnostic reference cell for detecting formation of a micro internal short circuit in each of the plurality of battery cells,
determine, based on voltage variations of the at least one diagnostic reference cell, whether a micro internal short circuit has formed in each of the plurality of battery cells, and
output, based on a determination that the micro internal short circuit has formed, a signal indicating detection of formation of the micro internal short circuit.

2. The apparatus of claim 1, wherein the at least one instruction, when executed by the processor, is configured to cause the apparatus to determine, as the at least one diagnostic reference cell, remaining battery cells other than an abnormal battery cell that has a greatest voltage variation among the plurality of battery cells.

3. The apparatus of claim 1 or 2, wherein the at least one instruction, when executed by the processor, is configured to cause the apparatus to detect a micro internal short circuit in each of the plurality of battery cells based on a difference between a voltage variation of each of the plurality of battery cells and a median value of voltage variations of the at least one diagnostic reference cell, wherein, optionally, the at least one instruction, when executed by the processor, is configured to cause the apparatus to repeatedly detect, at least a target quantity of times, a battery cell among the plurality of battery cells as having a micro internal short circuit, based on a difference exceeding a diagnostic threshold, wherein the difference is between the voltage variation of the battery cell and the median value of the voltage variations of the at least one diagnostic reference cell.

4. The apparatus of anyone of claims 1-3, wherein the at least one instruction, when executed by the processor, is configured to cause the apparatus to determine a voltage variation for each battery cell among the plurality of battery cells as a difference between a first voltage of each battery cell and a second voltage of each battery cell, wherein the first voltage is an open circuit voltage (OCV) measured in an ignition-off (IG off) state of the vehicle, and wherein the second voltage is an OCV measured in an ignition-on (IG on) state of the vehicle, wherein, optionally, the at least one instruction, when executed by the processor, is configured to cause the apparatus to store, as the first voltage, an OCV measured when a power a vehicle control circuit of the vehicle is turned back on after the vehicle transitions into a turned-off state in response to the IG off state of the vehicle.

5. The apparatus of claim 4, wherein the at least one instruction, when executed by the processor, is configured to cause the apparatus to:
initialize the first voltage and the second voltage based on a determination, in the IG on state, that the OCV stored as the first voltage is absent, and
store, as the first voltage, an OCV measured in a next IG off state of the vehicle.

6. The apparatus of claim 4 or 5, wherein the at least one instruction, when executed by the processor, is configured to cause the apparatus to store, as the second voltage, an OCV measured in the IG on state, based on a state of charge (SOC) of the plurality of battery cells being equal to or above a target level and a temperature of the plurality of battery cells being equal to or above a target temperature.

7. A method performed by an apparatus of a vehicle, the method comprising:
determining, based on voltage variations of a plurality of battery cells of the vehicle, at least one of the plurality of battery cells as at least one diagnostic reference cell for detecting formation of a micro internal short circuit in each of the plurality of battery cells;
determining, based on voltage variations of the at least one diagnostic reference cell, whether a micro internal short circuit has formed in each of the plurality of battery cells; and
outputting, based on a determination that the micro internal short circuit has formed, a signal indicating detection of formation of the micro internal short circuit.

8. The method of claim 7, wherein the determining of the at least one diagnostic reference cell comprises determining, as the at least one diagnostic reference cell, remaining battery cells other than an abnormal battery cell that has a greatest voltage variation among the plurality of battery cells.

9. The method of claim 7 or 8, wherein the determining of whether the micro internal short circuit has formed comprises detecting a micro internal short circuit in each of the plurality of battery cells based on a difference between a voltage variation of each of the plurality of battery cells and a median value of voltage variations of the at least one diagnostic reference cell, wherein, optionally, the determining of whether the micro internal short circuit has formed comprises repeatedly detecting, at least a target quantity of times, a battery cell among the plurality of battery cells as having a micro internal short circuit, based on a difference exceeding a diagnostic threshold, wherein the difference is between the voltage variation of the battery cell and the median value of the voltage variations of the at least one diagnostic reference cell.

10. The method of anyone of claims 7-9, further comprising:
determining a voltage variation for each battery cell among the plurality of battery cells as a difference between a first voltage of each battery cell and a second voltage of each battery cell,
wherein the first voltage is an open circuit voltage (OCV) measured in an ignition-off (IG off) state of the vehicle, and wherein the second voltage is an OCV measured in an ignition-on (IG on) state of the vehicle, wherein, optionally, the first voltage comprises an OCV measured when a power of the vehicle is turned back on after the power of the vehicle is turned off in response to the IG off state of the vehicle, and/or wherein, optionally, the first voltage comprises an OCV measured in a next IG off state of the vehicle, based on a determination, in the IG on state, that the OCV stored as the first voltage is absent.

11. A vehicle comprising:
a battery pack comprising a plurality of battery cells;
a sensor configured to measure open circuit voltages of the plurality of battery cells; and
a processor circuit configured to:
store, as a first voltage, an open circuit voltage of each of the plurality of battery cells measured in an ignition-off state of the vehicle,
store, as a second voltage, an open circuit voltage of each of the plurality of battery cells measured in an ignition-on state of the vehicle,
determine a voltage variation of each of the plurality of battery cells based on a difference between the first voltage and the second voltage of the corresponding battery cell,
identify at least one abnormal battery cell as a battery cell having a voltage variation greater than a threshold value,
select, as diagnostic reference cells, remaining battery cells excluding the at least one abnormal battery cell,
determine, for each of the plurality of battery cells, whether a micro internal short circuit has formed based on a comparison between the voltage variation of each of the plurality of battery cells and a median of the voltage variations of the diagnostic reference cells, and
output an indicator associated with the micro internal short circuit.

12. The vehicle of claim 11, wherein the processor circuit is configured to identify the at least one abnormal battery cell as a battery cell having a greatest voltage variation among the plurality of battery cells, wherein the greatest voltage variation exceeds the threshold value.

13. The vehicle of claim 11 or 12, wherein the processor circuit is configured to determine that a micro internal short circuit has formed based on a difference between the voltage variation of one of the plurality of battery cells and the median exceeding a preset threshold voltage value.

14. The vehicle of anyone of claims 11-13, wherein the processor circuit is configured to determine that a micro internal short circuit has formed based on detecting a difference exceeding a preset threshold voltage value for at least a preset quantity of times, and wherein the difference exceeding the preset threshold voltage value is between the voltage variation of one of the plurality of battery cells and the median.

15. The vehicle of anyone of claims 11-14, wherein the processor circuit is configured to measure the second voltage under a predetermined operating condition, wherein the predetermined operating condition comprises at least one of a state-of-charge condition of the battery pack or a temperature condition of the battery pack.

## Amended claims

### Amended claims in accordance with Rule 137(2) EPC.

1. An apparatus of a vehicle, the apparatus comprising:
a processor (1100); and
a memory (1300) storing at least one instruction that, when executed by the processor (1100), is configured to cause the apparatus to:
determine, based on voltage variations of a plurality of battery cells of the vehicle, at least one of the plurality of battery cells as at least one diagnostic reference cell for detecting formation of a micro internal short circuit in each of the plurality of battery cells,
determine, based on voltage variations of the at least one diagnostic reference cell, whether a micro internal short circuit has formed in each of the plurality of battery cells, and
output, based on a determination that the micro internal short circuit has formed, a signal indicating detection of formation of the micro internal short circuit,
**characterized in that** the at least one instruction, when executed by the processor (1100), is configured to cause the apparatus to:
identify, as an abnormal battery cell, a battery cell having a greatest voltage variation among the plurality of battery cells, and
determine, as the at least one diagnostic reference cell, remaining battery cells other than the abnormal battery cell.

2. The apparatus of claim 1, wherein the at least one instruction, when executed by the processor (1100), is configured to cause the apparatus to detect a micro internal short circuit in each of the plurality of battery cells based on a difference between a voltage variation of each of the plurality of battery cells and a median value of voltage variations of the at least one diagnostic reference cell.

3. The apparatus of claim 2, wherein the at least one instruction, when executed by the processor (1100), is configured to cause the apparatus to repeatedly detect, at least a target quantity of times, a battery cell among the plurality of battery cells as having a micro internal short circuit, based on a difference exceeding a diagnostic threshold, wherein the difference is between the voltage variation of the battery cell and the median value of the voltage variations of the at least one diagnostic reference cell.

4. The apparatus of anyone of claims 1-3, wherein the at least one instruction, when executed by the processor (1100), is configured to cause the apparatus to determine a voltage variation for each battery cell among the plurality of battery cells as a difference between a first voltage of each battery cell and a second voltage of each battery cell, wherein the first voltage is an open circuit voltage (OCV) measured in an ignition-off (IG off) state of the vehicle, and wherein the second voltage is an OCV measured in an ignition-on (IG on) state of the vehicle.

5. The apparatus of claim 4, wherein the at least one instruction, when executed by the processor (1100), is configured to cause the apparatus to store, as the first voltage, an OCV measured when a power of a vehicle control circuit of the vehicle is turned back on after the vehicle transitions into a turned-off state in response to the IG off state of the vehicle.

6. The apparatus of claim 4 or 5, wherein the at least one instruction, when executed by the processor (1100), is configured to cause the apparatus to:
initialize the first voltage and the second voltage based on a determination, in the IG on state, that the OCV stored as the first voltage is absent, and
store, as the first voltage, an OCV measured in a next IG off state of the vehicle.

7. The apparatus of anyone of claims 4-6, wherein the at least one instruction, when executed by the processor (1100), is configured to cause the apparatus to store, as the second voltage, an OCV measured in the IG on state, based on a state of charge (SOC) of the plurality of battery cells being equal to or above a target level and a temperature of the plurality of battery cells being equal to or above a target temperature.

8. A method performed by an apparatus of a vehicle, the method comprising:
determining, based on voltage variations of a plurality of battery cells of the vehicle, at least one of the plurality of battery cells as at least one diagnostic reference cell for detecting formation of a micro internal short circuit in each of the plurality of battery cells;
determining, based on voltage variations of the at least one diagnostic reference cell, whether a micro internal short circuit has formed in each of the plurality of battery cells; and
outputting, based on a determination that the micro internal short circuit has formed, a signal indicating detection of formation of the micro internal short circuit,
**characterized in that** the determining of the at least one diagnostic reference cell comprises identifying, as an abnormal battery cell, a battery cell having a greatest voltage variation among the plurality of battery cells, and determining, as the at least one diagnostic reference cell, remaining battery cells other than the abnormal battery cell.

9. The method of claim 8, wherein the determining of whether the micro internal short circuit has formed comprises detecting a micro internal short circuit in each of the plurality of battery cells based on a difference between a voltage variation of each of the plurality of battery cells and a median value of voltage variations of the at least one diagnostic reference cell.

10. The method of claim 9, wherein the determining of whether the micro internal short circuit has formed comprises repeatedly detecting, at least a target quantity of times, a battery cell among the plurality of battery cells as having a micro internal short circuit, based on a difference exceeding a diagnostic threshold, wherein the difference is between the voltage variation of the battery cell and the median value of the voltage variations of the at least one diagnostic reference cell.

11. The method of anyone of claims 8-10, further comprising:
determining a voltage variation for each battery cell among the plurality of battery cells as a difference between a first voltage of each battery cell and a second voltage of each battery cell, wherein the first voltage is an open circuit voltage (OCV) measured in an ignition-off (IG off) state of the vehicle, and wherein the second voltage is an OCV measured in an ignition-on (IG on) state of the vehicle.

12. The method of claim 11, wherein the first voltage comprises an OCV measured when a power of the vehicle is turned back on after the power of the vehicle is turned off in response to the IG off state of the vehicle.

13. The method of claim 11 or 12, wherein the first voltage comprises an OCV measured in a next IG off state of the vehicle, based on a determination, in the IG on state, that the OCV stored as the first voltage is absent.

14. A vehicle comprising:
a battery pack comprising a plurality of battery cells;
a sensor (300) configured to measure open circuit voltages of the plurality of battery cells; and
an apparatus according to anyone of claims 1-7.
